Europäisches Patentamt

European Patent Office

Office européen des brevets

(19)

(11) EP 0 853 335 A2

## (12) EUROPEAN PATENT APPLICATION

(43) Date of publication:
15.07.1998 Bulletin 1998/29

(51) Int Cl.⁶: H01L 21/3105, C09G 1/02

(21) Application number: 98300155.3

(22) Date of filing: 09.01.1998

(84) Designated Contracting States:
AT BE CH DE DK ES FI FR GB GR IE IT LI LU MC
NL PT SE
Designated Extension States:
AL LT LV MK RO SI

(30) Priority: 10.01.1997 US 35020 P

(71) Applicant: TEXAS INSTRUMENTS
INCORPORATED
Dallas Texas 75265 (US)

(72) Inventors:
• Morrison, William Robert
  Dallas, Texas 75240 (US)
• Hunt, Kyle Paul
  Dallas, Texas 75230 (US)

(74) Representative: Darby, David Thomas et al
Abel & Imray
Northumberland House
303-306 High Holborn
London WC1V 7LH (GB)

### (54) Slurry and process for the mechano-chemical polishing of semiconductor devices

(57) This invention is for an improved slurry for shallow trench isolation processing. The improved slurry has an enhanced oxide to nitride polish removal selectivity. The invention relates to a modified slurry formed by mixing a polishing slurry with tetramethyl ammonium hydroxide and hydrogen peroxide. In an alternative embodiment, the modified slurry is formed by mixing a salt of tetramethyl ammonium with a base and with hydrogen peroxide to form the modified slurry.

EP 0 853 335 A2

## Description

TECHNICAL FIELD OF THE INVENTION

The present invention relates to an improved slurry for shallow trench isolation processing in the chemical mechanical polishing of semiconductor devices. Specifically, the invention relates to a modified slurry formed by mixing a polishing slurry with a salt of tetramethyl ammonium, a base, and hydrogen peroxide. Alternatively, the modified slurry is formed by mixing a slurry with tetramethyl ammonium hydroxide and hydrogen peroxide to increase the oxide to nitride polish removal selectivity.

BACKGROUND OF THE INVENTION

Various isolation structures are presently used for fabricating semiconductor devices. For example, shallow isolation structures are used in order to isolate adjacent electronic devices (such as transistors) which are formed in fabricating certain semiconductor circuits. Typically, such shallow isolation structures are created using the well-known LOCal Oxidation of Silicon (LOCOS) isolation technique. In the LOCOS process, a pad-oxide ($SiO_2$) layer is first grown on the surface of a semiconductor substrate while a silicon nitride ($Si_3N_4$) layer is then deposited over the pad-oxide layer. Using well-known methods, these layers are then patterned to define the width of the shallow recess to be etched in the substrate. Once the shallow recess has been etched, the substrate is subjected to an oxidation process where silicon dioxide ($SiO_2$) is grown in the recess; the silicon nitride layer which has not yet been removed prevents any oxide growth over the surface of the substrate. As a result, oxide grows to fill the entire recess including the opening in the patterned oxide and silicon nitride layers which defined the width of the shallow recess.

The disadvantages to this process is that the silicon dioxide formed in the recessed opening is grown in an isotropic manner, which consumes surface area on the semiconductor circuit. This causes the adjacent electronic devices that are being separated to be a fixed minimum distance apart.

Another technique used to create transistor isolation structures is by using a trench. This method is known as Shallow Trench Isolation (STI). In the STI process, a pad-oxide ($SiO_2$) layer is grown on the semiconductor substrate after which a silicon nitride ($Si_3N_4$) layer is then deposited on the pad-oxide layer. Using well known methods the $Si_3N_4$ layer is patterned and etched to the determined widths of the isolation structures. Next, the semiconductor substrate is etched to form trenches and the surface is deposited with silicon dioxide to fill the trenches above the top of the silicon nitride junction level. Again, using well known methods, the semiconductor device is reverse patterned and etched before using chemical mechanical polishing (CMP).

One disadvantage to this method is that the slurry used to polish at CMP has a selectivity of 4:1 silicon dioxide to silicon nitride polish rate. This causes tight margins in the capability of the CMP process, because if the nitride is polished away and the substrate is exposed, the electronic devices will not function properly and transistor characteristics will be adversely affected (e.g.: double Vt, double hump) . Another disadvantage is that the silicon dioxide formed after the reverse pattern and etch is able to break off and cause scratching during the CMP process.

Machines for fabricating semi-conductor circuits are known in the art. CMP polishing of the wafers are to form a planar surface at different levels of fabrication. In general, the polishing process is accomplished by using an abrasive slurry. In this procedure, a wafer mounted on a rotating carrier is brought into contact with a rotating polishing pad upon which is sprayed a slurry of insoluble abrasive particles suspended in a liquid. CMP is the combination of mechanical and chemical abrasion, and may be performed with an acidic or basic slurry. Material is removed from the wafer due to both the mechanical buffing and the action of the acid or base.

The CMP process is known to provide excellent local planarity. Global planarity is affected by feature height, size, layout, density and polishing conditions such as mechanical polishing parameters, pad and slurry.

In using CMP for the STI process, basic or alkaline slurry materials may be used. It is advantageous to enhance the removal rate of oxide, while diminishing the removal rate of nitride. An ideal planarization process would remove topography of different geometries simultaneously without dishing in wide low regions. However, current CMP processes in STI applications without patterned etch back using conventional 4:1 selectivity slurries cause dishing and damage to silicon in isolated regions, making it unsuitable for production use. Dishing occurs because of longer polish times and pad deflection in the large field areas. Therefore, reverse etch is used to reduce the polish time and thus, the dishing.

STI planarization using CMP usually requires an extra patterning step and reverse pattern etch, thereby increasing the expense. Thus, an inexpensive one step CMP process could be achieved for STI planarization if a slurry having a selectivity of greater than 20:1 oxide:nitride polish removal rate could be used.

Various methods have been tried to reduce the dishing problem. Boyd and Ellul (J.M. Boyd, et al., Electochem. Soc. Proc., Vol. 95-5, 1996, p. 290) reported the use of a thin nitride overcoat deposited on top of the gap filled oxide to reduce dishing. The nitride overcoat provides protection to the underlying oxide in low lying regions while the high level oxide is being polished at a much faster rate due to the oxide:nitride selectivity of 4:1. The CMP process time window can be reduced by using a slurry which has a high oxide removal rate. This slurry should also have a low nitride removal rate in order to achieve simultaneous local as well as global planarization. Therefore, a slurry with a high oxide:nitride selectivity is desired for STI applications.

SUMMARY OF THE INVENTION

The present invention provides a method of enhancing the polish removal selectivity in shallow trench isolation, comprising polishing a semiconductor device with a modified slurry, said modified slurry formed by the process of combining a slurry with salt of tetramethyl ammonium, a base, and hydrogen peroxide to form a modified slurry having enhanced polish removal selectivity. Preferably, the salt of tetramethyl ammonium is tetramethyl ammonium fluoride. The modified slurry preferably has a pH of 11 to 12.9, and most preferably 11.6 to 11.9.

The present invention also provides a slurry having enhanced polish removal selectivity produced by the process of combining a slurry with tetramethyl ammonium hydroxide and with hydrogen peroxide to form a modified slurry having enhanced polish removal selectivity. This modified slurry preferably has a pH of 11 to 12.9, and most preferably 11.5 to 12.0.

Other embodiments and advantages of the invention are set forth, in part, in the description which follows and, in part, will be obvious from this description and may be learned from practice of the invention.

DETAILED DESCRIPTION OF THE INVENTION

CMP processing requires a high polish removal selectivity for optimal STI structures to be fabricated on the semiconductor surface. As used herein, the phrase "polish removal selectivity" refers to the ratio of removal of silicon dioxide ($SiO_2$) to silicon nitride ($Si_3N_4$). In prior art techniques, the polish removal selectivity is most commonly 4:1. By using the techniques described herein, enhanced polish removal selectivity ratios of greater than 15:1 are achieved. As used herein, the phrase "enhanced polish removal selectivity" refers to a polish selectivity of 15:1 or greater. The technique involves modification of basic slurry compositions to achieve the enhanced polish removal selectivity.

In a preferred embodiment of the present invention, tetramethyl ammonium hydroxide (TMAH) and hydrogen peroxide are added to a slurry to improve the polish removal selectivity. Namely a slurry with an enhanced polish removal selectivity of 30:1 has been achieved. In an alternative embodiment, different salts of tetramethyl ammonium (TMA) and a highly basic solution are added to the slurry to enhance polish removal selectivity. A slurry using this method has shown an enhanced polish removal selectivity of 15:1.

A suitable slurry is a colloidal silica formulation having an initial pH of around 10.5. Suitable slurries include, but are not limited to, Cabot (El Dorado Hills, CA, USA) SC112 or Rodel (Newark, Delaware) ILD1300. The slurries are the mainstream slurries used in oxide polish operations by most major US semiconductor manufacturers. In the preferred embodiment of the present invention, the slurry is SC112 from Cabot.

When the correct amount of tetramethyl ammonium hydroxide (TMAH) alone is used (without $H_2O_2$), the pH may become greater than 13, causing the silica or other suspended particulates to become non-colloidal (charge loss) and to fall out of suspension. Thus, the colloidal nature of the slurry is lost and slurry performance is adversely affected. The hydrogen peroxide is introduced to lower the pH to less than 13, thereby preventing silica dissolution from the slurry. It is preferable that the final pH of the slurry (after addition of the TMAH and $H_2O_2$) be in the range of 11.0 to 12.9, and most preferably in the range of 11.5 to 12.0. It is also preferable that the slurry to TMAH ratio (volume:volume) is between 50:1 to 55:1, or between 50 and 55 parts slurry to 1 part TMAH. The ratio of slurry to $H_2O_2$ is preferably between 300:1 to 500:1 (volume:volume). For all mixtures described herein, the TMAH has a 25% concentration (2.7 moles/L) and the hydrogen peroxide used has a 30% concentration (9.8 moles/L). With this modified slurry formulation, an enhanced polish removal selectivity of greater than 15:1 oxide to nitride is achieved. In fact, enhanced polish removal selectivity ratios of 30:1 may be obtained.

TMAH is known to have stability problems because of its degradation into trimethyl amines. This breakdown causes the performance of the slurry to degrade over time. Hence, it is preferable that the modified slurry be used soon after it is prepared. The modified slurry should be used within two hours after preparation, as the polish removal selectivity of the modified slurry diminishes to below 5:1 after about 3 hours.

Useful salts of TMA include, but are not limited to chloride, bromide, iodide, sulfide, or fluoride salts. Most preferably, the TMA salt is tetramethylammonium fluoride added to increase the pH to 11 to 12.9, and most preferably to 11.6 to 11.9. The correct pH is maintained by a basic solution such as, but not limited to potassium hydroxide. This modified slurry provides a selectivity of 15:1 or greater.

Interestingly, salts of tetraethyl ammonium hydroxide and of tetrabutyl ammonium hydroxide are not effective in enhancing polish removal selectivity.

The following examples are offered to illustrate embodiments of the invention and should not be viewed as limiting the scope of the invention.

Example 1: Use of TMAH and Hydrogen Peroxide

This example describes the polish removal selectivity of TMAH used in conjunction with hydrogen peroxide. Pilot wafers (non-patterned) were ran on both Plasma enhanced tetra ethyl ortho silicate (PETEOS) and Low pressure, chemical vapor deposited silicon nitride (LPCVD nitride). We mixed the slurry using the above formulations and polished the wafers on a Westech 472 polishing machine. Each pilot wafer was polished for 2 minutes using a slurry flow of 150 milliliters per minute. Pre- and post- measurements of the wafer thickness were made using a calibrated Tencor FT750.

The Westech tool parameters for the polish process for all experiments to test the slurry are shown below:

Table Speed: 60 RPM
Carrier Speed: 45 RPM
Down Force: 7 PSI
Backpressure: 1.SPSI

The polish rate of the PETEOS and LPCVD nitride was measured. The following formula was used to calculate selectivity:

1)     XX = oxide polish rate / nitride polish rate.

This is expressed as XX:1 oxide to nitride selectivity, where "XX" is calculated as above.

2)     Polish rate = [Post thickness ( ) - Pre thickness ( )] / time (minutes)

These terms can be found in the semiconductor literature and are common definitions in the semiconductor field. Below is the data reflecting the various ratios of TMAH and $H_2O_2$ added to SC112 to achieve different desired selectivities. The numbers in the table are expressed as ratios of volume of 25% TMAH (2.7 moles/L) and 30% $H_2O_2$ (8.8 moles/L) added to 3000 ml of SC112 slurry.

Table 1

| Oxide and Nitride Removal Rates (RR) | | | | |
|---|---|---|---|---|
| Ratios of TMAH and $H_2O_2$ are in volume:volume | | | | |
| TMAH | $H_2O_2$ | Oxide (RR) | Nitride (RR) | Selectivity |
| 30:1 | 150:1 | 100 | 7.5 | 13:1 |
| 100:1 | 150:1 | 2500 | 700 | 4:1 |
| 52:1 | 300:1 | 530 | 17.6 | 30:1 |
| 125:1 | 300:1 | 2600 | 700 | 4:1 |

The ratio of slurry to TMAH (volume:volume) was varied from 30:1 up to 125:1. Hydrogen peroxide was used to adjust the pH to values of 11.3 and 12.3. At a ratio of 52:1 of slurry to TMAH, the etch selectivity was 30:1.

Table 2 shows that an optimal pH of about 11.7 is preferable.

Table 2

| Oxide and Nitride Removal Rates (RR) | | | | | |
|---|---|---|---|---|---|
| TMAH | $H_2O_2$ | Oxide (RR) | Nitride (RR) | Selectivity | pH |
| 53:1 | 300:1 | 450 | 17.7 | 25.3:1 | 11.7 |
| 54:1 | 400:1 | 950 | 50 | 19:1 | 11.5 |
| 111:1 | 500:1 | 2400 | 600 | 4:1 | 11.1 |
| 69:1 | 500:1 | 2400 | 400 | 6:1 | 11.3 |
| 54:1 | 500:1 | 460 | 20 | 23:1 | 11.7 |

Example 2: Use of a TMA Fluoride Salt

This investigation was conducted to explore the contribution of a fluoride salt of TMA to the slurry. The example was conducted as described above in example 1, except tetramethyl ammonium fluoride salt was added to the slurry at the ratios given.

The mixtures included adding 40% TMA(F), $H_2O_2$ and 8 molar potassium hydroxide (KOH) to 2000 ml of SC112. The KOH was used to maintain a basic pH.

Table 3

| Selectivity with Fluoride Salt | | | |
|---|---|---|---|
| TMA(F) | $H_2O_2$ | KOH | Selectivity |
| 10:1 | 500:1 | 200:1 | 6:1 |
| 15:1 | 500:1 | 200:1 | 8:1 |
| 17.5:1 | 500:1 | 200:1 | 15:1 |
| 20:1 | 500:1 | 200:1 | 13:1 |

These data show that fluoride salts of tetramethyl ammonium can be used to decrease the nitride removal rate, therefore increasing the oxide to nitride selectivity.

Although the present invention has been described in detail, it should be understood that various changes, alterations and substitutions may be made to the teachings herein without departing from the spirit and scope of the present invention.

**Claims**

1.  A method of enhancing the polish removal selectivity in shallow trench isolation, comprising:

    forming a modified slurry by combining a slurry with salt of tetramethyl ammonium, a base, and hydrogen peroxide to form a slurry having enhanced polish removal selectivity; and
    polishing a semiconductor device with said modified slurry.

2.  The method of Claim 1, wherein said combining step comprises combining said slurry with a salt of tetramethyl ammonium selected from a group of materials comprising: chloride, bromide, iodide, sulfide and fluoride.

3.  The method of Claim 1 or Claim 2, wherein said combining step comprises combining said slurry with a salt comprising tetramethyl ammonium flouride.

4.  The method of any of Claims 1 to 3, wherein said step of forming said modified slurry comprises forming a modified slurry having a pH of 11.0 to 12.9.

5.  The method of any of Claims 1 to 4, wherein said step of forming said modified slurry comprises forming a modified slurry having a pH of 11.6 to 11.9.

6.  A modified slurry having enhanced polish removal selectivity comprising: a combination of a slurry with tetramethyl ammonium hydroxide and with hydrogen peroxide.

7.  The modified slurry of Claim 6, having a ratio of slurry to tetramethyl ammonium hydroxide of 50:1 to 55:1 (volume: volume).

8.  The modified slurry of Claim 6 or Claim 7, having a ratio of slurry to hydrogen peroxide of 200:1 to 500:1 (volume: volume).

9.  The modified slurry of any of Claims 6 to 8, wherein said modified slurry has a pH of 11.0 to 12.9, preferably of 11.5 to 12.0.

10. A polishing slurry comprising peroxide and tetramethyl ammonium ions, and optionally fluoride ions, the slurry advantageously having a pH within the range of from 11.0 to 12.9, and the use thereof in polishing with enhanced selectivity, especially in shallow trench isolation.